# FASCICULE DE BREVET EUROPEEN

(11) **EP 2 846 176 B1**
(45) Date de publication et mention de la délivrance du brevet: **30.03.2022**
(21) Numéro de dépôt: 14306307.1
(22) Date de dépôt: 25.08.2014
(51) Int. Cl.: G01V 8/02, G01C 11/06, G01V 9/00

(54) **Procédé d'exploitation d'un gisement souterrain comprénant au moins un affleurement géologique au moyen d'une photogrammétrie**
Verfahren zum Ausbeuten einer untertägigen Lagerstätte mit mindestens einem Aufschluss mittels Photogrammetrie
Method for the exploitation of a subsurface deposit including at least one outcrop by means of photogrammetry

(30) Priorité: 04.09.2013 FR 1358480
(43) Date de publication de la demande: 11.03.2015
(73) Titulaire: IFP Energies nouvelles, 92500 Rueil-Malmaison (FR)
(72) Inventeur: Deschamps, Rémy, 78360 Montesson (FR); Schmitz, Julien, 78360 Montesson (FR); Daniel, Jean-Marc, 78400 Chatou (FR); Joseph, Philippe, 78160 Marly le Roi (FR)
(74) Mandataire: IFP Energies nouvelles

(56) Documents cités:
- US-A- 3 124 038
- Matthew F Fey: "DIGITAL OUTCROP MAPPING OF A RESERVOIR-SCALE INCISED VALLEY FILL, SEGO SANDSTONE, BOOK CLIFFS, UTAH A Thesis", , 31 août 2006 (2006-08-31), XP055116041, Extrait de l'Internet: URL:http://repository.tamu.edu/bitstream/h andle/1969.1/ETD-TAMU-1794/FEY-THESIS.pdf? sequence=2 [extrait le 2014-04-30]
- WILLIAM C HANEBERG ET AL: "Digital Outcrop Characterization for 3-D Structural Mapping and Rock Slope Design Along Interstate 90 Near Snoqualmie Pass, Washington", PROCEEDINGS 57 TH ANNUAL HIGHWAY GEOLOGY SYMPOSIUM, 29 septembre 2006 (2006-09-29), XP055116059,
- JOHN B THURMOND ET AL: "Collection, Evaluation, and Use Outcrop Data in the 21 st Century - New methods and applications, with example from the Ainsa Turbidite System, Ainsa, Spain - Chapter 118", ATLAS OF DEEP-WATER OUTCROPS, AAPG STUDIES IN GEOLOGY, vol. 56, 31 décembre 2007 (2007-12-31), XP055116018, ISBN: 9780891810636

## Description

La présente invention concerne le domaine de la caractérisation d'analogues de gisement souterrain, tel qu'un réservoir d'hydrocarbures, un gisement minier ou une carrière, à partir d'un modèle géologique.

L'industrie pétrolière, et plus précisément l'exploration et l'exploitation de gisements pétroliers, nécessite d'acquérir une connaissance aussi parfaite que possible de la géologie souterraine pour fournir de façon efficace une évaluation des réserves, une modélisation de la production, ou une gestion optimisée de l'exploitation. En effet, la détermination de l'emplacement d'un puits de production ou d'un puits d'injection, les paramètres nécessaires à la récupération optimales des hydrocarbures, tels que la pression d'injection, la constitution de la boue de forage, les caractéristiques de complétion... nécessitent de bien connaître le gisement. Connaître le gisement signifie connaître les caractéristiques du sous-sol en tout point de l'espace. Ceci implique de connaître l'architecture de ce sous-sol, c'est-à-dire de définir la géométrie et la nature des couches géologiques constituant ce sous-sol. La complexité de l'architecture sédimentaire d'un réservoir engendre des difficultés pour la modélisation du gisement. On peut observer en particulier différentes surfaces se recoupant, dues à la succession de remplissages et d'érosions. L'architecture géologique définit ainsi différents objets géologiques, auxquels on peut attacher des propriétés pétrophysiques pour améliorer la caractérisation du gisement, et donc les différentes évaluations.

Depuis longtemps, l'industrie pétrolière allie les mesures techniques aux modélisations, réalisées en laboratoire et/ou par des logiciels, notamment au moyen d'une analyse des affleurements du gisement.

En géologie, un affleurement est un ensemble de roches non séparées du sous-sol, qui a été mis à nu par un ensemble de facteurs naturels (érosion hydraulique, glaciaire ou marine) ou humains. Les études d'affleurements analogues et /ou reliés aux gisements en subsurface, c'est à dire d'affleurements ayant les mêmes caractéristiques en termes d'âge géologique, de conditions et d'environnement de dépôt, de type de roche, etc., que le gisement profond permettent d'acquérir une compréhension plus détaillée de leur géométrie, de leurs hétérogénéités et de leurs caractéristiques pétrophysiques.

De plus, l'étude d'affleurements peut être également utile pour la modélisation de gisement minier ou pour la modélisation de carrière afin d'optimiser leur exploitation.

Les modélisations d'analogues à l'affleurement des gisements constituent donc une étape technique indispensable à toute exploration ou exploitation de gisement. Ces modélisations ont pour but de fournir une description du gisement, via son architecture sédimentaire et/ou ses propriétés pétrophysiques.

Le récent engouement pour la représentation 3D (trois Dimensions) d'affleurement à suscité le développement de techniques de reconstitution d'affleurement en 3D, dont celle du Lidar (de l'anglais : Light Détection and Ranging signifiant télédétection par Laser), pour laquelle de nombreux efforts et moyens ont été mis en oeuvre pour intégrer cette technologie dans les méthodes de modélisation géologique. Cette méthode à été éprouvée, et si elle permet d'avoir une reconstitution 3D des affleurements précise, elle s'avère par contre très difficile à employer et à manipuler. En effet, le nuage de points généré sur les images à manipuler est important, les moyens informatiques nécessaires sont conséquents, ce qui réduit nettement la souplesse d'utilisation de cette méthode. Par ailleurs, les dispositifs d'acquisition Lidar sont lourds (plusieurs dizaines de kilogrammes de matériel à emporter sur le terrain, le plus souvent héliportés), ce qui rend cette méthode très contraignante et très coûteuse.

On connait en outre les documents :
- Matthew F Fey, "Digital outcroup mapping of reservoir-scale incised valley fill, sego sandstone, book cliffs, Utah", A thesis, Texas A&M University, August 2006*,* qui concerne une méthode de construction d'un modèle 3D digital par photogrammétrie ;
- William C Haneberg et al, "Digital outcrop characterization for 3-D structural mapping and rock slope design along interstate 90 near snoqualmie pass, Washington", 57th Annual Highway Geology Symposium, Colorado, September 26-29, 2006*,* qui concerne une méthode de construction par photogrammétrie d'une représentation tridimensionnelle digitale d'un affleurement ;
- Tore M. Loseth, John B. Thurmond, Jan C. Rivenæs, Ole J. Martinsen, Carlos Aiken, Xueming Xu, 2008. "Using Outcrop Data in the 21st Century, Atlas of Deep-Water Outcrops", Volume 56 DOI: https://doi.org/10.1306/St561240 American Association of Petroleum Geologists ISBN electronic: 9781629810331, Publication date: January 01, 2008*,* qui décrit des méthodes utilisant des informations provenant d'affleurements, notamment par photogrammétrie ;
- US 3124038, qui concerne une méthode pour dessiner les contours d'affleurements par photogrammétrie.

Pour pallier cette méthode couteuse en termes de moyens d'acquisition et de traitement, ainsi que de lourdeur de manipulation, l'invention concerne un procédé d'exploitation d'un gisement souterrain comprenant au moins un affleurement, l'exploitation du gisement est basée sur un modèle géologique formé à partir d'une photogrammétrie. Le procédé s'attache à reconstruire les affleurements géologiques en trois dimensions à partir de photographies, et à en interpréter les éléments géologiques, telles que les surfaces sédimentaires, les faciès géologiques, les failles et les fractures, l'inclinaison des couches... pour construire un modèle géologique du gisement. L'acquisition des données par cette méthode est peu coûteuse et souple d'utilisation.

### Le procédé selon l'invention

L'invention concerne un procédé d'exploitation d'un gisement souterrain comprenant au moins un affleurement géologique. Pour ce procédé, on réalise les étapes suivantes:
a) on acquiert au moins deux photographies géoréférencées dudit affleurement géologique prises à partir de positions différentes;
b) on construit une représentation tridimensionnelle dudit affleurement géologique à partir desdites photographies géoréférencées en utilisant un logiciel de reconstruction photogrammétrique;
c) on détermine au moins une caractéristique dudit affleurement au moyen de ladite représentation tridimensionnelle de l'affleurement, ladite détermination utilisant une méthode de traitement d'image de ladite représentation tridimensionnelle réalisée par ordinateur et comprenant une première étape de reconnaissance de faciès et une seconde étape de construction de lignes et de surfaces;
d) on construit un modèle géologique dudit gisement souterrain; et
e) on exploite ledit gisement souterrain en mettant en oeuvre un schéma d'exploitation défini au moyen dudit modèle géologique;
le procédé étant caractérisé en ce que ladite détermination d'au moins une caractéristique dudit affleurement comprend aussi une analyse statistique de ladite représentation tridimensionnelle dudit affleurement de manière à déterminer au moins un jeu de paramètres géostatistiques pour contraindre un modèle géologique dudit gisement souterrain, ledit jeu de paramètres géostatistiques consistant en des courbes de proportion et des matrices de proportion de la constitution du sol interprétées sur ledit affleurement et leurs variogrammes en fonction de la distance; et ledit modèle géologique dudit gisement souterrain est construit au moyen de ladite caractéristique dudit affleurement et dudit jeu de paramètres géostatistiques pour contraindre ledit modèle géologique.

Selon l'invention, ladite caractéristique dudit affleurement est de nature géologique, géométrique, statistique et/ou géostatistique.

Avantageusement, ladite caractéristique dudit affleurement est choisie parmi une définition des surfaces délimitant des unités géologiques dudit affleurement, une définition des surfaces des failles et/ou des fractures, une géométrie des différents corps géologiques et une définition des faciès sédimentaires.

Selon un mode de réalisation de l'invention, on construit ladite représentation tridimensionnelle de l'affleurement au moyen d'un algorithme de reconstruction, à partir desdites photographies géoréférencées.

De préférence, ledit algorithme de reconstruction met en oeuvre les étapes suivantes :
i) détermination d'au moins un paramètre relatif auxdites prises de vue photographiques ;
ii) détermination de la profondeur de l'affleurement au moyen desdites photographies géoréférencées et dudit paramètre ; et
iii) construction de la représentation tridimensionnelle en fonction de ladite profondeur de l'affleurement et desdites photographies géoréférencées.

Avantageusement, on analyse les dimensions des corps sédimentaires, des hétérogénéités, des failles et/ou des fractures dudit affleurement.

De manière avantageuse, on acquiert lesdites photographies géoréférencées depuis le sol et/ou depuis les airs.

Selon l'invention, ledit gisement souterrain est un réservoir d'hydrocarbures, un gisement minier ou une carrière.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon l'invention, lorsque ledit programme est exécuté sur un ordinateur.

### Présentation succincte des figures

D'autres caractéristiques et avantages du procédé selon l'invention, apparaîtront à la lecture de la description ci-après d'exemples non limitatifs de réalisations, en se référant aux figures annexées et décrites ci-après.
La figure 1 illustre les étapes du procédé selon l'invention.
La figure 2 illustre un exemple du procédé selon l'invention.

### Description détaillée de l'invention

L'invention concerne un procédé d'exploitation d'un gisement souterrain (réservoir d'hydrocarbures pour la récupération d'hydrocarbures ou pour le stockage de CO₂, mine, carrière) pour lequel on construit un modèle géologique du gisement en déterminant certaines caractéristiques sur un affleurement analogue géologiquement, et sur la base d'une méthode de photogrammétrie.

On rappelle qu'en géologie, un affleurement est un ensemble de roches non séparées du sous-sol, qui a été mis à nu par un ensemble de facteurs naturels (érosion hydraulique, glaciaire ou marine) ou humains.

La photogrammétrie est une technique de mesure pour laquelle les coordonnées en trois dimensions des points d'un objet (ici d'un affleurement) sont déterminées par des mesures faites en deux images photographiques (ou plus) prises à partir de positions différentes.

Un modèle géologique (ou modèle de réservoir) est une représentation de la distribution spatiale des propriétés géologiques et pétrophysiques comme les faciès, les perméabilités ou les porosités d'un gisement souterrain. Un tel modèle géologique constitue une maquette du sous-sol, représentative à la fois de sa structure et de son comportement. Généralement, ce type de maquette est représenté sur un ordinateur, et l'on parle alors de modèle numérique. Un modèle géologique numérique est basé sur une grille (ou maillage) généralement tridimensionnelle, dont la géométrie représente celle de l'objet étudié (ici le gisement souterrain), et dans laquelle des propriétés géologiques et pétrophysiques (faciès, porosité, perméabilité, saturation...) sont associées à chaque maille. Les modèles géologiques et les modèles de réservoir bien connus et largement utilisés dans l'industrie pétrolière, permettent de déterminer de nombreux paramètres techniques relatifs à l'étude ou l'exploitation d'un réservoir, d'hydrocarbures par exemple. En effet, puisque le modèle géologique est représentatif de la structure du réservoir et de son comportement, l'ingénieur l'utilise dans le domaine de la récupération d'hydrocarbures par exemple pour déterminer les zones qui ont le plus de chances de contenir des hydrocarbures, les zones dans lesquelles il peut être intéressant/nécessaire de forer un puits d'injection ou de production pour améliorer la récupération des hydrocarbures, le type d'outils à utiliser, les propriétés des fluides utilisés et récupérés.... Ces interprétations de modèles géologiques en termes de « paramètres techniques d'exploitation » sont bien connues des spécialistes. Un modèle géologique a donc pour vocation de rendre compte, au mieux, de toutes les informations connues sur un gisement souterrain. Un modèle géologique numérique est représentatif de la réalité lorsqu'une simulation de (production du) réservoir pour ce modèle fournit des résultats en terme d'historique de production très proches des données observées. Une simulation de réservoir est une technique permettant de simuler les écoulements de fluides au sein d'un réservoir au moyen d'un logiciel appelé simulateur d'écoulement, et du modèle de réservoir. Par exemple, le logiciel PumaFlow ^{™} (IFP Énergies nouvelles, France) est un simulateur d'écoulement.

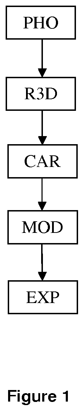

Selon l'invention et tel que représenté sur la figure 1, le procédé d'exploitation d'un gisement souterrain comprenant au moins un affleurement géologique comporte les étapes suivantes :
1. Acquisition de photographies (PHO)
2. Construction d'une représentation tridimensionnelle de l'affleurement (R3D)
3. Détermination des caractéristiques de l'affleurement (CAR)
4. Construction d'un modèle géologique (MOD)
5. Exploitation du gisement souterrain (EXP)

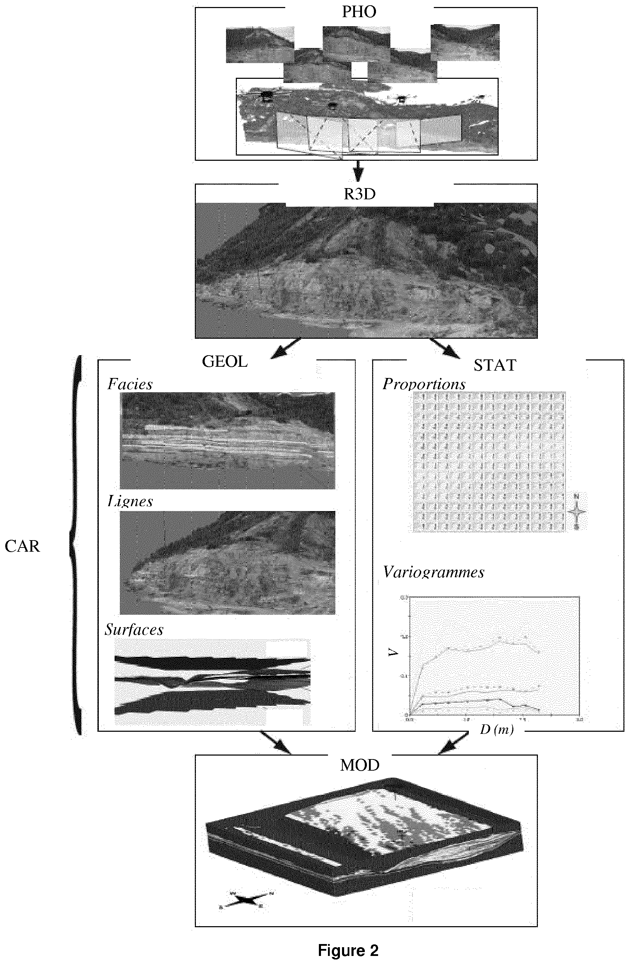

La figure 2 illustre ces différentes étapes pour un exemple d'application.

### 1. Acquisition de photographies (PHO)

La première étape consiste à acquérir les données d'entrées pour la construction de la représentation tridimensionnelle de l'affleurement. Il s'agit d'au moins deux, de préférence au moins trois prises de vues photographiques des affleurements sur le terrain. Chaque prise de vue est géoréférencée, c'est-à-dire positionnée dans l'espace (en trois dimensions), afin de pouvoir replacer la ou les représentations 3D d'affleurements dans un espace géographique, tels qu'ils le sont dans la réalité.

Les prises de vue peuvent être terrestres ou aéroportées, notamment à bord d'un hélicoptère ou au moyen d'un drone télécommandé.

Avantageusement, les photographies peuvent être prises suivant un protocole précis qui permettra une reconstruction précise en 3D de la surface de l'affleurement texturé. Le protocole peut prévoir notamment un recouvrement des photographies.

L'acquisition des données par cette méthode ne nécessite donc pas de matériel onéreux et lourd, seul un appareil photo numérique suffit. De plus, l'acquisition des données par cette méthode ne nécessite pas de moyens informatiques importants, et par conséquent cette méthode est peu coûteuse et souple d'utilisation.

Sur la figure 2, l'étape d'acquisition (PHO) illustre cinq photographies aériennes d'un affleurement ainsi que les zones de l'affleurement photographiées. On réalise un recouvrement de ces zones pour une meilleure reconstruction de l'affleurement.

### 2. Construction d'une représentation tridimensionnelle de l'affleurement (R3D)

Cette étape concerne la reconstruction en 3D des affleurements photographiés. Cette reconstruction est réalisée par un algorithme de reconstruction photogrammétrique, qui prend en compte les photographies et leur géoréférencement. Concernant la reconstruction photogrammétrique, les coordonnées en trois dimensions des points de l'affleurement sont déterminées par des mesures faites par au moins deux images photographiques prises à partir de positions différentes, en utilisant la parallaxe entre les images. La représentation tridimensionnelle obtenue à la fin de cette étape est une image en 3D de l'affleurement. L'algorithme de reconstruction peut prendre en compte les données techniques relatives aux prises de vue photographiques, notamment la distance focale de l'objectif de l'appareil.

Le processus de reconstruction peut se résumer en 4 étapes :
a- Calibration de l'appareil photographique :
   Cette étape consiste à déterminer les paramètres intrinsèques (longueur focale, taille de l'image et point principal) et extrinsèques (géoréférencement - position de l'appareil dans des coordonnées 3D réelles) de l'appareil utilisé.
b- Calcul de la profondeur
   Cette partie du calcul va déterminer la profondeur des objets représentés sur des images 2D (photos). Différentes cartes de profondeur peuvent être ainsi calculées.
c- Reconstruction et maillage :
   Les différentes cartes de profondeur générées précédemment sont utilisées pour reconstruire le modèle dans son ensemble. Le nuage de points résultant de ce calcul peut être ensuite triangulé pour obtenir le maillage final.
d- Extraction de texture :
   Cette dernière étape consiste à extraire les textures des photos originales et de les appliquer au maillage obtenu dans l'étape précédente afin de créer le modèle maillé et texturé utilisable pour les étapes suivantes. Dans le domaine de la synthèse d'image, une texture est une image en deux dimensions (2D) que l'on va appliquer sur une surface (2D) ou un volume en trois dimensions (3D) de manière à habiller cette surface ou ce volume.

Par exemple pour cette reconstruction, on peut utiliser un logiciel de reconstruction photogrammétrique, tel que le logiciel Smart3DCapture^{™} (Acute 3D, France).

L'étape de construction d'une représentation tridimensionnelle (R3D) est illustrée pour un exemple en figure 2.

### 3. Détermination des caractéristiques de l'affleurement (CAR)

La troisième étape concerne l'exploitation de la représentation 3D de l'affleurement, avec l'interprétation et l'édition des éléments géologiques observés et décrits sur le terrain. Il s'agit d'éditer sur le modèle 3D des caractéristiques qui sont utiles pour contraindre les modèles géologiques, c'est à dire de déterminer une ou plusieurs caractéristiques géologiques, géométriques, statistique ou géostatistique de l'affleurement. Pour cela, on utilise une méthode de traitement d'image, qui traite la représentation tridimensionnelle de l'affleurement construite à l'étape précédente.

Cette méthode de traitement d'image est réalisée par ordinateur et offre les possibilités interactives suivantes : le picking (i.e. la détermination d'un objet sur une image par sélection par clic de l'utilisateur), l'habillage de l'image 3D par classes de textures (régions de caractéristiques, motifs, plages de couleurs, etc... homogènes), le filtrage, la reconnaissance automatique de formes... On rappelle que dans le domaine de la synthèse d'image, une texture est une image en deux dimensions (2D) que l'on va appliquer sur une surface (2D) ou un volume en trois dimensions (3D) de manière a habiller cette surface ou ce volume.

Selon un mode de réalisation de l'invention, la caractéristique déterminée peut concerner :
- les surfaces remarquables délimitant des unités géologiques présentant des caractéristiques distinctes ;
- la construction de surfaces et de régions correspondants à des unités géologiques présentant des caractéristiques qui induisent par la suite des méthodes de simulation distinctes ;
- la construction de surfaces correspondants aux couloirs de failles et/ ou de fractures en respectant leurs orientations dans l'espace ;
- les géométries des différents corps géologiques (chenaux, troncatures, clinoformes, rejets de failles, couloirs de fractures...) ; et
- les faciès sédimentaires (faciès réservoirs, hétérogénéités...).

Cette liste est non exhaustive.

De plus, des analyses statistiques et des calculs de paramètres géostatistiques de propriétés interprétées sur la représentation de l'affleurement en 3D sont mises en œuvre, afin de fournir un jeu de paramètres géostatistiques et de contraintes le plus complet possible pour la construction du modèle géologique. Avantageusement, cette analyse peut avoir lieu de façon indépendante à la suite de la seconde étape de construction de la représentation tridimensionnelle. Il s'agit dans cette partie d'analyser et de quantifier certains attributs géologiques sur l'image 3D d'affleurement de façon statistique en complément à l'édition des éléments géologiques suscités.
- La partie analyse d'image permet de quantifier la taille des objets géologiques (dimensions des corps sédimentaires, des hétérogénéités de réservoirs, espacement des fractures, répartition des failles et fractures dans l'espace...).
- La partie quantification des éléments et propriétés géologiques interprétés sur l'affleurement 3D concerne les outils géostatistiques qui permettent de calculer les paramètres les plus importants utilisés pour la modélisation de réservoir. Il s'agit de calculer directement sur l'affleurement les courbes de proportion ainsi que les matrices de proportion des propriétés interprétées sur l'affleurement (faciès...), ainsi que les variogrammes, qui servent ensuite directement de contraintes géostatistiques pour la construction du modèle géologique.

L'étape de détermination de caractéristiques de l'affleurement (CAR) est illustrée en figure 2 pour un exemple. Pour cet exemple, on réalise à la fois la détermination de caractéristiques géologiques (GEOL) de l'affleurement et une analyse statistique (STAT). Pour la détermination de caractéristiques géologiques (GEOL), on réalise une première étape de reconnaissance de faciès, puis une seconde étape de construction de lignes (de l'anglais "polylines drawing"), et une étape de construction de surfaces. Pour l'analyse statistique (STAT), on estime les proportions de la constitution du sol (argile, grès, boue, conglomérats...) et un peut former leurs variogrammes (V) en fonction de la distance (D).

### 4. Construction d'un modèle géologique (MOD)

Lors de cette étape, on construit un modèle géologique (ou, le cas échéant, un modèle de réservoir) du gisement souterrain, le modèle étant contraint au niveau de l'affleurement par les caractéristiques et les contraintes déterminées à l'étape précédente. En effet, les modélisations de l'affleurement ont pour but de fournir une description du gisement, via son architecture sédimentaire et/ou ses propriétés pétrophysiques.

Ces caractéristiques et ces contraintes fournissent un panel de contraintes géométriques, faciologiques, statistiques et géostatistiques qui peuvent être exportés directement dans des géomodeleurs comme Petrel^{™} (Schlumberger, USA) ou Gocad^{™} (Paradigm, USA).

Le modèle géologique peut être également contraint par d'autres données acquises sur le gisement souterrain : par exemple par des données de production au puits dans le cadre de récupération d'hydrocarbures, par des données pétrophysiques au niveau des puits...

L'étape de construction du modèle géologique de la figure 2 illustre le modèle obtenu suite aux précédentes étapes au moyen d'un géomodeleur du type Petrel^{™} (Schlumberger, USA) ou Gocad^{™} (Paradigm, USA).

### 5. Exploitation du gisement souterrain (EXP)

Si le gisement est un réservoir d'hydrocarbures, on simule, au moyen d'un simulateur d'écoulement, par exemple le logiciel PumaFlow^{™} (IFP Énergies nouvelles, France), les écoulements du fluide injecté et des hydrocarbures présents dans le réservoir à partir du modèle de réservoir choisi à l'étape précédente. On peut simuler par exemple la récupération de pétrole ou les déplacements des fluides (par exemple les gaz stockés) dans le réservoir.

Selon un mode de réalisation de l'invention, à partir du modèle de réservoir déterminé lors des étapes précédentes, les spécialistes peuvent déterminer plusieurs schémas d'exploitation correspondant à différentes configurations possibles d'exploitation du réservoir souterrain : emplacement des puits producteurs et/ou injecteurs, valeurs cibles pour les débits par puits et/ou pour le réservoir, le type d'outils utilisés, les fluides utilisés, injectés et/ou récupérés... Pour chacun de ces schémas, il convient de déterminer leurs prévisions de production. Ces prévisions de production probabilistes sont obtenues au moyen du logiciel de simulation d'écoulement ainsi qu'au moyen du modèle numérique de réservoir choisi.

On définit alors un ou plusieurs schémas d'exploitation possibles adaptés au modèle de réservoir. Pour chacun de ces schémas, on peut déterminer les réponses par simulation.

A partir des prévisions de productions probabilistes définies pour chaque schéma d'exploitation, les spécialistes peuvent par comparaison choisir le schéma d'exploitation qui leur semble le plus pertinent. Par exemple :
- en comparant le maximum du volume d'huile récupéré, on peut déterminer le schéma de production susceptible de fournir le maximum de récupération ou d'être le plus rentable.
- en comparant l'écart type du volume d'huile récupéré, on peut déterminer le schéma de production le moins risqué.

On exploite alors le réservoir en fonction de la simulation ou le cas échéant en fonction du schéma d'exploitation le plus pertinent, par exemple en forant de nouveaux puits (producteur ou injecteur), en modifiant les outils utilisés, en modifiant les débits et/ou la nature de fluides injectés et/ou stockés (cas du stockage de CO₂)...

Si le gisement souterrain est un gisement minier ou une carrière, le modèle géologique est utilisé pour déterminer les zones d'intérêt pour l'exploitation du gisement. A partir de ces zones, on définit un ou plusieurs schémas d'exploitation du gisement souterrain, en prenant en compte les conditions opératoires : quantité de matière récupérable, quantité de matière non exploitable, durée d'exploitation, type d'outils à utiliser... Et en fonction de ces conditions d'exploitation, les spécialistes peuvent par comparaison choisir le schéma d'exploitation qui semble le plus pertinent. On exploite alors le gisement souterrain en récupérant des matières, en modifiant les outils utilisés, en modifiant les techniques de récupération de la matière...

L'invention concerne par ailleurs un produit programme d'ordinateur téléchargeable depuis un réseau de communication et/ou enregistré sur un support lisible par ordinateur et/ou exécutable par un processeur. Ce programme comprend des instructions de code de programme pour la mise en œuvre du procédé tel que décrit ci-dessus, lorsque le programme est exécuté sur un ordinateur.

## Revendications

1. Procédé d'exploitation d'un gisement souterrain comprenant au moins un affleurement géologique, dans lequel on réalise les étapes suivantes :
a) on acquiert au moins deux photographies géoréférencées dudit affleurement géologique (PHO) prises à partir de positions différentes ;
b) on construit une représentation tridimensionnelle dudit affleurement géologique à partir desdites photographies géoréférencées (R3D) en utilisant un logiciel de reconstruction photogrammétrique ;
c) on détermine au moins une caractéristique (CAR) dudit affleurement au moyen de ladite représentation tridimensionnelle de l'affleurement, ladite détermination utilisant une méthode de traitement d'image de ladite représentation tridimensionnelle réalisée par ordinateur et comprenant une première étape de reconnaissance de faciès et une seconde étape de constructions de lignes et de surfaces (GEOL) ;
d) on construit un modèle géologique (MOD) dudit gisement souterrain ; et
e) on exploite ledit gisement souterrain en mettant en œuvre un schéma d'exploitation défini au moyen dudit modèle géologique (EXP) ;
le procédé étant **caractérisé en ce que** :
ladite détermination d'au moins une caractéristique (CAR) dudit affleurement comprend aussi une analyse statistique (STAT) de ladite représentation tridimensionnelle dudit affleurement de manière à déterminer au moins un jeu de paramètres géostatistiques pour contraindre ledit modèle géologique dudit gisement souterrain, ledit jeu de paramètres géostatistiques consistant en des courbes de proportion et des matrices de proportion de la constitution du sol interprétées sur ledit affleurement et leurs variogrammes en fonction de la distance ; et
ledit modèle géologique (MOD) dudit gisement souterrain est construit au moyen de ladite caractéristique (CAR) dudit affleurement et dudit jeu de paramètres géostatistiques pour contraindre ledit modèle géologique (MOD) ;

2. Procédé selon la revendication 1, dans lequel ladite caractéristique dudit affleurement est de nature géologique, géométrique, statistique et/ou géostatistique.

3. Procédé selon la revendication 2, dans lequel ladite caractéristique dudit affleurement est choisie parmi une définition des surfaces délimitant des unités géologiques dudit affleurement, une définition des surfaces des failles et/ou des fractures, une géométrie des différents corps géologiques et une définition des faciès sédimentaires.

4. Procédé selon l'une des revendications précédentes, dans lequel on construit ladite représentation tridimensionnelle de l'affleurement au moyen d'un algorithme de reconstruction, à partir desdites photographies géoréférencées.

5. Procédé selon la revendication 4, dans lequel ledit algorithme de reconstruction met en œuvre les étapes suivantes :
i) détermination d'au moins un paramètre relatif auxdites prises de vue photographiques ;
ii) détermination de la profondeur de l'affleurement au moyen desdites photographies géoréférencées et dudit paramètre ; et
iii) construction de la représentation tridimensionnelle en fonction de ladite profondeur de l'affleurement et desdites photographies géoréférencées.

6. Procédé selon l'une des revendications précédentes, dans lequel on analyse les dimensions des corps sédimentaires, des hétérogénéités, des failles et/ou des fractures dudit affleurement.

7. Procédé selon l'une des revendications précédentes, dans lequel on acquiert lesdites photographies géoréférencées depuis le sol et/ou depuis les airs.

8. Procédé selon l'une des revendications précédentes, dans lequel ledit gisement souterrain est un réservoir d'hydrocarbures, un gisement minier ou une carrière.

9. Produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon l'une des revendications précédentes, lorsque ledit programme est exécuté sur un ordinateur.

## Patentansprüche

1. Verfahren zur Ausbeutung eines unterirdischen Vorkommens, das mindestens einen geologischen Aufschluss enthält, wobei die folgenden Schritte durchgeführt werden:
a) es werden mindestens zwei georeferenzierte Fotografien des geologischen Aufschlusses (FO) erfasst, die ausgehend von unterschiedlichen Positionen aufgenommen werden;
b) es wird eine dreidimensionale Darstellung des geologischen Aufschlusses ausgehend von den georeferenzierten Fotografien (R3D) unter Verwendung einer fotogrammetrischen Rekonstruktions-Software konstruiert;
c) es wird mindestens ein Merkmal (CAR) des Aufschlusses mittels der dreidimensionalen Darstellung des Aufschlusses bestimmt, wobei die Bestimmung eine computerimplementierte Bildverarbeitungsmethode der dreidimensionalen Darstellung verwendet und einen ersten Schritt der Erkennung von Fazies und einen zweiten Schritt der Konstruktion von Linien und Flächen (GEOL) enthält;
d) es wird ein geologisches Modell (MOD) des unterirdischen Vorkommens konstruiert; und
e) das unterirdische Vorkommen wird ausgebeutet, indem ein mittels des geologischen Modells (EXP) definiertes Ausbeutungsschema angewendet wird;
wobei das Verfahren **dadurch gekennzeichnet ist, dass**:
die Bestimmung mindestens eines Merkmals (CAR) des Aufschlusses auch eine statistische Analyse (STAT) der dreidimensionalen Darstellung des Aufschlusses enthält, um mindestens einen Satz geostatischer Parameter zu bestimmen, um das geologische Modell des unterirdischen Vorkommens einzuschränken, wobei der Satz geostatischer Parameter aus am Aufschluss interpretierten Proportionskurven und Proportionsmatrizen der Beschaffenheit des Bodens und ihren Variogrammen abhängig von der Entfernung besteht; und
das geologische Modell (MOD) des unterirdischen Vorkommens mittels des Merkmals (CAR) des Aufschlusses und des Satzes geometrischer Parameter konstruiert wird, um das geologische Modell (MOD) einzuschränken.

2. Verfahren nach Anspruch 1, wobei das Merkmal des Aufschlusses von geologischer, geometrischer, statistischer und/oder geostatischer Art ist.

3. Verfahren nach Anspruch 2, wobei das Merkmal des Aufschlusses unter einer Definition der geologische Einheiten des Aufschlusses begrenzenden Flächen, einer Definition der Flächen der Verwerfungen und/oder der Brüche, einer Geometrie der verschiedenen geologischen Körper und einer Definition der sedimentären Fazies ausgewählt wird.

4. Verfahren nach einem der vorhergehenden Ansprüche, wobei die dreidimensionale Darstellung des Aufschlusses mittels eines Rekonstruktionsalgorithmus ausgehend von den georeferenzierten Fotografien konstruiert wird.

5. Verfahren nach Anspruch 4, wobei der Rekonstruktionsalgorithmus die folgenden Schritte verwendet:
i) Bestimmung mindestens eines Parameters bezüglich der fotografischen Aufnahmen;
ii) Bestimmung der Tiefe des Aufschlusses mittels der georeferenzierten Fotografien und des Parameters; und
iii) Konstruktion der dreidimensionalen Darstellung abhängig von der Tiefe des Aufschlusses und den georeferenzierten Fotografien.

6. Verfahren nach einem der vorhergehenden Ansprüche, wobei die Abmessungen der Sedimentkörper, der Heterogenitäten, der Verwerfungen und/oder der Brüche des Aufschlusses analysiert werden.

7. Verfahren nach einem der vorhergehenden Ansprüche, wobei die georeferenzierten Fotografien vom Boden und/oder aus der Luft erfasst werden.

8. Verfahren nach einem der vorhergehenden Ansprüche, wobei das unterirdische Vorkommen ein Kohlenwasserstoffreservoir, ein Grubenvorkommen oder ein Steinbruch ist.

9. Computerprogrammprodukt, das von einem Kommunikationsnetz herunterladbar und/oder auf einem computerlesbaren Träger gespeichert und/oder von einem Prozessor ausführbar ist, das Programmcodeanweisungen zur Durchführung des Verfahrens nach einem der vorhergehenden Ansprüche enthält, wenn das Programm auf einem Computer ausgeführt wird.

## Claims

1. Method for exploiting a subsoil deposit comprising at least one outcrop, wherein the following steps are carried out:
a) at least two georeferenced photographs of said outcrop (PHO) are acquired, taken from different positions;
b) a three-dimensional representation of said outcrop is constructed from said georeferenced photographs (R3D) by using photogrammetric reconstruction software;
c) at least one characteristic (CAR) of said outcrop is determined by means of said three-dimensional representation of the outcrop, said determination using an image processing method on said three-dimensional representation performed by computer and comprising a first step of recognizing facies and a second step of constructing lines and surfaces (GEOL);
d) a geological model (MOD) of said subsoil deposit is constructed; and
e) said subsoil deposit is exploited by implementing an exploitation scheme defined by means of said geological model (EXP);
the method being **characterized in that**:
said determination of at least one characteristic (CAR) of said outcrop also comprises a statistical analysis (STAT) of said three-dimensional representation of said outcrop so as to determine at least one set of geostatistical parameters to constrain said geological model of said subsoil deposit, said set of geostatistical parameters consisting of proportion curves and proportion matrices of the constitution of the ground interpreted on said outcrop and the variograms thereof as a function of the distance; and
said geological model (MOD) of said subsoil deposit is constructed by means of said characteristic (CAR) of said outcrop and of said set of geostatistical parameters to constrain said geological model (MOD);

2. Method according to Claim 1, wherein said characteristic of said outcrop is of geological, geometric, statistical and/or geostatistical nature.

3. Method according to Claim 2, wherein said characteristic of said outcrop is chosen from among a definition of the surfaces delimiting geological units of said outcrop, a definition of the surfaces of the faults and/or the fractures, a geometry of the various geological bodies and a definition of the sedimentary facies.

4. Method according to one of the preceding claims, wherein said three-dimensional representation of the outcrop is constructed by means of a reconstruction algorithm, from said georeferenced photographs.

5. Method according to Claim 4, wherein said reconstruction algorithm implements the following steps:
i) determination of at least one parameter relating to said photograph images;
ii) determination of the depth of the outcrop by means of said georeferenced photographs and of said parameter; and
iii) construction of the three-dimensional representation as a function of said depth of the outcrop and of said georeferenced photographs.

6. Method according to one of the preceding claims, wherein the dimensions of the sedimentary bodies, of the heterogeneities, of the faults and/or of the fractures of said outcrop are analysed.

7. Method according to one of the preceding claims, wherein said georeferenced photographs are acquired from the ground and/or from the air.

8. Method according to one of the preceding claims, wherein said subsoil deposit is a hydrocarbon reservoir, a mining deposit or a quarry.

9. Computer program product that can be downloaded from a communication network and/or stored on a computer-readable medium and/or that can be executed by a processor, comprising program code instructions for implementing the method according to one of the preceding claims, when said program is run on a computer.
